# EUROPEAN PATENT SPECIFICATION

(11) **EP 0 719 054 B1**
(45) Date of publication and mention of the grant of the patent: **14.06.2000**
(21) Application number: 95309414.1
(22) Date of filing: 22.12.1995
(51) Int. Cl.: H04N 7/52

(54) **Audio/video bit stream interleaving method for variable bit rate encoder**
Verfahren zur Verschachtelung eines Audio-/Video- Bitstromes für Kodierer mit veränderlicher Bitrate
Procédé d'entrelacement de train de bits audio/vidéo pour codeur à débit variable

(30) Priority: 24.12.1994 KR 9436518
(43) Date of publication of application: 26.06.1996
(73) Proprietor: LG ELECTRONICS INC., Seoul (KR)
(72) Inventor: Yoo, Jea Yong, Seoul (KR)
(74) Representative: McLeish, Nicholas Alistair Maxwell

(56) References cited:
- EP-A- 0 618 695
- US-A- 5 231 495
- SID INTERNATIONAL SYMPOSIUM DIGEST OF PAPERS, BOSTON, MAY 17 - 22, 1992, no. VOL. 23, 17 May 1992, SOCIETY FOR INFORMATION DISPLAY, pages 127-129, XP000479005 MACINNIS A G: "THE MPEG SYSTEMS SPECIFICATION: MULTIPLEX, CODING, AND CONSTRAINTS"
- ELECTRONICS & COMMUNICATIONS IN JAPAN, PART I - COMMUNICATIONS, vol. 73, no. 2 PART 01, 1 February 1990, pages 53-63, XP000140240 YOSHINORI SAKAI: "BURST MULTIPLEXING METHOD OF MULTIMEDIA SIGNALS BY COMMUICATION TERMINAL"

## Description

### Background of the Invention

The present invention relates to an encoding/decoding method of audio/video packet data by an MPEG(Moving Picture Expert Group) system, and more particularly, to an audio/video bit stream interleaving method for a variable bit rate encoder which can remove the overflow or underflow phenomena of a decoder by interleaving audio/video data taking into consideration of decoding time while decoding packet data.

Generally, in a system using the MPEG algorithm, the interleaving method is adapted for the decoder buffer to prevent the overflow or underflow from the audio/video data.

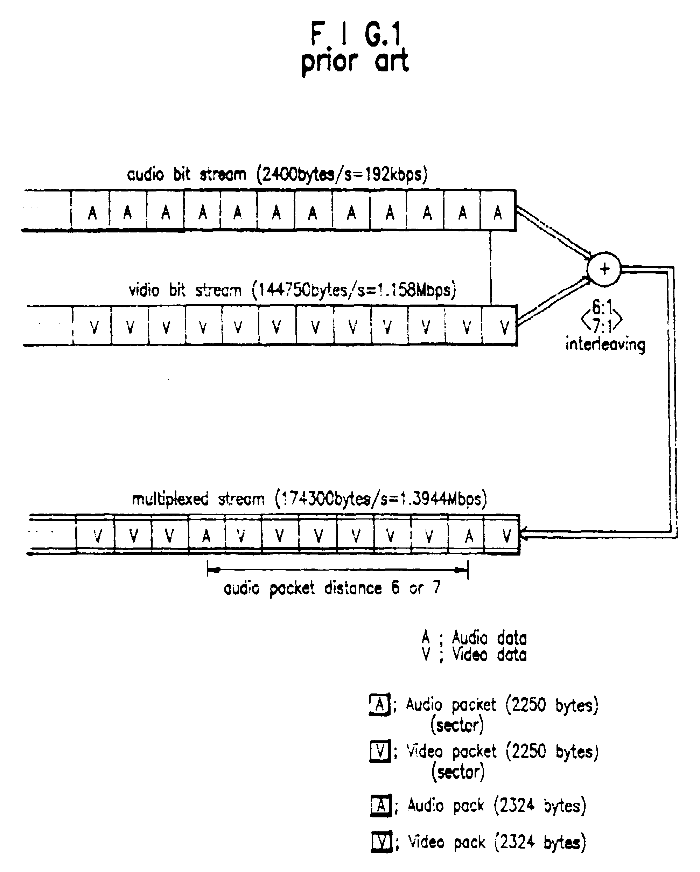

A conventional interleaving method of the audio/video packet data, as shown in Fig. 1, is performed in a variable bit rate encoder and includes an interleaving block.

In such an interleaving method, a reference interleaving element is a difference rate between an audio data rate and a video data rate. According to the difference rate, the interleaving is performed to precisely set the audio/video packet data rates to a predetermined period.

In Fig. 1, the data of which packs comprise a plurality of packets are formatted so as to arrange only one packet for a pack of the data.

Each audio/video packet precisely includes 2250bytes and each audio/video pack includes 2324bytes by adding pack headers of 74 bytes to the audio/video packets.

In more detail, the interleaving method of the above audio/video data, for example, of which audio data rate is 192 kbps and video data rate is 1,158mbps is as follows :
wherein if the audio data rate 192kbps is 2400bytes/second, the number of audio packets/second is determined by the following formular,$\text{the number of audio packets/second=} \frac{\text{audio data rate}}{\text{audio packet size}} \text{=} \frac{\text{24000bytes/s}}{\text{2250bytes}} \text{=10} \frac{\text{2}}{\text{3}} \text{,}$ and wherein if the video data rate 1.158mbps is 144750bytes/s, the number of video packets/second is determined by the following formular,$\text{the number of video packets/second=} \frac{\text{video packet rate}}{\text{video packet size}} \text{=} \frac{\text{144750 bytes/s}}{\text{2250 bytes}} \text{=64} \frac{\text{1}}{\text{3}}$

Therfore, the number of audio/video packet number/second is 10 $\frac{\text{2}}{\text{3}}$ + 64 $\frac{\text{1}}{\text{3}}$ = 75 packet/sec.
where, a three-second-period of interleaving method is chosen to change the audio/video packet numbers integers.

That is, if all packet numbers of three-second-period is 75 x 3=225 packets,$\text{three-second-period audio packet number = 10} \frac{\text{2}}{\text{3}} \text{x 3 = 32 packets,}$ and$\text{three-second-period video packet number = 64} \frac{\text{1}}{\text{3}} \text{x 3 = 193 packets.}$

Therefore, the packet rate of the time-second-period audio packet number and the three-second-period video packet number becomes$\frac{\text{video packet number}}{\text{audio packet number}} \text{=} \frac{\text{193}}{\text{32}} \text{= 6.03125.}$

The above packet rate 6.03125 is achieved by interleaving one audio packet after sixth and seventh video packet.

Therefore, all packets of 225 are to be formatted as follows :

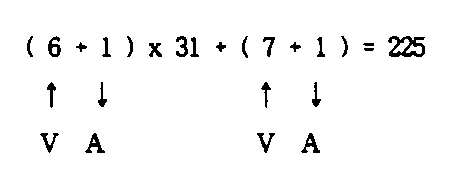

To descrbe the above formular in more detail, during every three seconds one audio packet is inserted after six video packets and after repeating this pattern 31 times, one more audio packet is inserted again after seven video packets.

The coventional interleaving method using the video/audio data rates as above is, however, not suitable for the variable bit rate system due to the disadvantages that the audio/vedio data rates system and the video data rate is varied while the audio data rate is fixed.

Prior art document EP-A-0 618695 discloses a method of forming a multiplexed datastream. Transfer of first and second data signals to a multiplexing circuit is controlled on the basis of the quantity of each data signal present in its respective storage device.

### Summary of the Invention

Accordingly, the present invention provides a method of interleaving an audio bitstream comprising sequential audio packets and a video bitstream comprising sequential video packets, and writing the packets to an output, at least some of both the audio and the video packets including presentation time stamps (PTS), characterised in that the method comprises the steps of:
for each audio and video packet, determining whether or not a PTS is present in the packet (S302, S303), and if not, creating a PTS for the packet by estimation using a PTS from a preceding packet from the same bit stream (S304);
comparing the PTS of a packet from a first of the audio and video bit streams with the PTS of a packet from the other stream (S307), and writing to the output the one of the compared packets which has the smaller PTS value (S307);
comparing the PTS of the packet not written to the output in the previous method step with the PTS of the next packet from the stream from which a packet was written to the output in the previous method step (S307), and writing to the output the one of the packets compared in the present method step which has the smaller PTS value (S307); and
repeating the previous method step to process further packets from the streams, thereby multiplexing the audio and video bit streams to form a single audio/video bit stream.

Embodiments of the invention provide an audio/video bit stream interleaving method for a variable bit rate encoder in which the interleaving is performed with reference to a PTS(Presentation Time Stamp) exsiting in a packet header.

Embodiments of the invention further provide an audio/video bit stream interleaving method for a variable bit rate encoder comprising the steps of detecting the presence of a PTS in audio/video packets for estimating from a preceding PTS a current one in the absence of the PTS, comparing PTSs of the audio/video packets to output an alternative packet having smaller PTS, and multiplexing the audio or video packets to form an audio/video bit stream.

### Brief Description of the Drawings

Fig. 1 is a block diagram for explaining a conventional interleaving method for the audio/video packet data of a variable bit rate encoder :
Fig 2 is a block diagram for explaining an interleaving method for the audio/video packet data of a variable bit rate encoder according to a preferred embodiment of the present invention and
Fig. 3 is a flow chart of the interleaving method for the audio/video bit stream of the variable bit rate encoder according to the preferred embodiment of the present invention.

### Detailed Description of the Invention

Hereinafter, a preferred embodiment of an audio/video bit stream interleaving method of a variable bit rate encoder will be described with reference to the attached drawing.

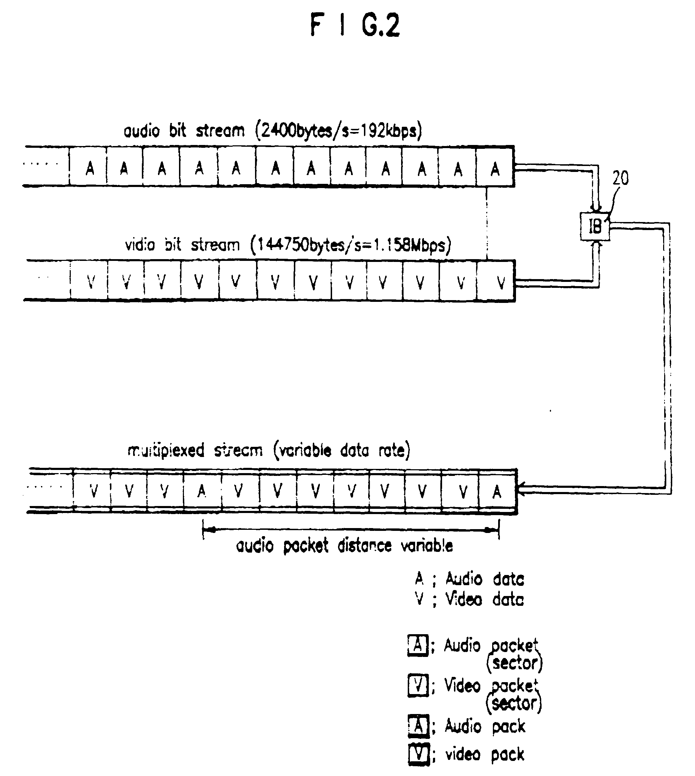

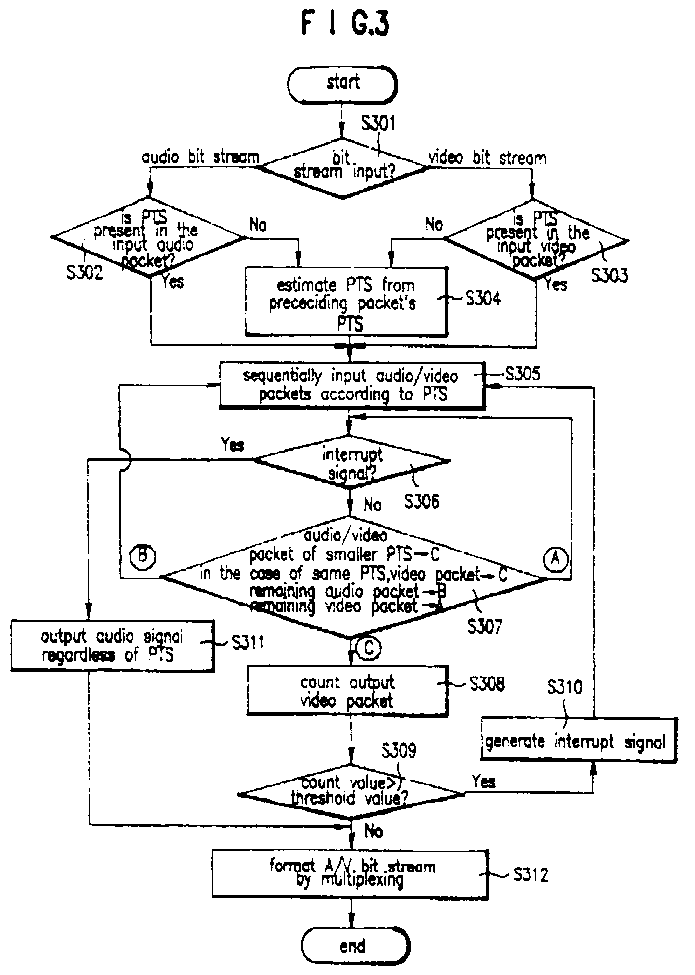

Fig.2 is a block diagram for explaining an interleaving method for the audio/video packet data of a variable bit rate encoder embodying the present invention, and Fig. 3 is a flow chart of an interleaving method for the audio/video bit stream of the variable bit rate encoder according to a preferred embodiment of the present invention.

Referring to Fig 2, an audio bit stream is input to an interleaving block (20) at a fixed data rate. On the other hand a video bit stream has a variable data rate so that maximum bit rate and minimum bit rates are set while encoding, where its total average bit rate is used to set a threshold value in the interleaving block (20). According to the threshold value, the maximum audio packet distance of a multiplexed bit stream is determined.

Referring to Fig. 3, the audio/video bit stream interleaving method of the variable bit rate encoder is described in more detail.

As the bit stream is input to the interleaving block (20), it is determined as to whether the input bit stream is an audio bit stream or a video bit stream (S301), it is determined as to whether the audio bit stream or video bit stream has a PTS on the header information area of its packet (S302, S303), and if the PTS is proved to be absent from the determination steps (S302) or (S303), the PTS is estimated from a preceding PTS for the audio packet or video packet(S304).

The estimation of the PTS is carried out by the MPEG algorithm from the below formula :${\text{PTS = NINT(System clock frequency * (tpn(k))% 2}}^{\text{33}}$ (tpn(k) is the presentation time at kth presentation.)
where, the bit size is that of the bit after the preceding PTS, and the system clock frequency is the average data rate.

Next, according to the PTS audio/video packets are sequentially input (S305). Then, one audio packet and one video packet respectively having a packet value are compared with each other to output the audio or video packet having smaller PTS value alternatively, and the remaining video or audio packet is compared with another input packet, where the video packet is output in case of the same PTS values (S307).

In order to prevent the video packet from overflow due to the maximum audio rate, the pass of the video packet is counted (S308). After comparing the counted value with a threshold value (S309), if the counted value is larger than the threshold value, an interrupt signal is generated (S310) to determine the presence of such an interrupt signal (S306) before the above step (S307). Therefore, if the interrupt signal is proved to be present, the audio packet is output regardless of the PTS value (S311). The video packets or audio packets ouput through the above steps (S301-S309) are multiplexed to form an audio/video bit stream.

In the above described interleaving method, the PTS is one of the most important factor, where the PTS of an audio packet represents a time for the audio data output after decoding and the PTS of a video packet represents the time to be displayed on a screen, being respectively shown in proportion to an SCR (System Clock Reference).

In this case, since the PTS is present usually in In this an interval less than 0.7sec., a PTS of a linear packet is minute and has no influence on a decoder buffer.

As described above, the audio/video bit stream interleaving method for the variable bit rate encoder comprises the steps of determining the presence of the PTS in the input audio/video packets to estimate a current PTS from a preceding PTS in the abscence of the PTS, comparing the audio packet with the video packet in the PTS to output one of the packets having smaller PTS value, and multiplexing the audio or video packets to form the audio/video bit stream, so that the audio/video packets to be input in a predetermined period rather than to be input in one period are subject to the interleaving entirely by the audio/video pack.

Therefore, according to the interleaving method described above, the interleaving is effectively achieved by preventing the decoder from the overflow or underflow by using the PTS of the packet header regardless of the size of the audio/video packets.

## Claims

1. A method of interleaving an audio bitstream comprising sequential audio packets and a video bitstream comprising sequential video packets, and writing the packets to an output, at least some of both the audio and the video packets including presentation time stamps (PTS), characterised in that the method comprises the steps of:
for each audio and video packet, determining whether or not a PTS is present in the packet (S302, S303), and if not, creating a PTS for the packet by estimation using a PTS from a preceding packet from the same bit stream (S304);
comparing the PTS of a packet from a first of the audio and video bit streams with the PTS of a packet from the other stream (S307), and writing to the output the one of the compared packets which has the smaller PTS value (S307);
comparing the PTS of the packet not written to the output in the previous method step with the PTS of the next packet from the stream from which a packet was written to the output in the previous method step (S307), and writing to the output the one of the packets compared in the present method step which has the smaller PTS value (S307); and
repeating the previous method step to process further packets from the streams, thereby multiplexing the audio and video bit streams to form a single audio/video bit stream.

2. An method according to claim 1 in which the PTS of a packet is formatted in a packet head information area.

3. A method according to claim 1 wherein the number of video packets written sequentially to the output is counted (S308), an audio packet being written to the output regardless of the PTS values of the compared packets if the counted value exceeds a threshhold value (S311).

4. A method according to claim 1 wherein a video packet is written to the output if compared audio and video packets have the same PTS values (S307).

5. A method according to claim 3 wherein the threshold value is determined by an average bit rate of the total audio bit stream.

6. Apparatus comprising means for carrying out the steps of the method according to any one of claims 1-5.

## Patentansprüche

1. Verfahren zur Verschachtelung eines aufeinanderfolgende Tonpakete umfassenden Tonbitstroms und eines aufeinanderfolgende Bildpakete umfassenden Bildbitstroms und zum Schreiben der Pakete an einen Ausgang, wobei zumindest einige sowohl der Ton- als auch der Bildpakete Präsentationszeitmarken (PTS) enthalten,
**dadurch gekennzeichnet,** daß das Verfahren die Schritte umfaßt:
- für jedes Ton- und Bildpaket Bestimmen, ob in dem Paket eine PTS vorhanden ist oder nicht (S302, S303), und - falls nicht - Erzeugen einer PTS für das Paket durch Ermittlung anhand einer PTS eines vorhergehenden Pakets aus dem gleichen Bitstrom (S304),
- Vergleichen der PTS eines Pakets aus einem ersten der Ton- und Bildbitströme mit der PTS eines Pakets aus dem anderen Strom (S307) und Schreiben desjenigen der verglichenen Pakete, das den kleineren PTS-Wert hat, an den Ausgang (S307),
- Vergleichen der PTS des bei dem vorangehenden Verfahrensschritt nicht an den Ausgang geschriebenen Pakets mit der PTS des nächsten Pakets aus dem Strom, aus dem beim vorangehenden Verfahrensschritt ein Paket an den Ausgang geschrieben wurde (S307), und Schreiben desjenigen der bei dem momentanen Verfahrensschritt verglichenen Pakete, das den kleineren PTS-Wert hat, an den Ausgang (S307), und
- Wiederholen des vorhergehenden Verfahrensschritts zur Verarbeitung weiterer Pakete aus den Strömen, wodurch die Ton- und Bildbitströme zur Bildung eines einzelnen Ton-/Bildbitstroms multiplexiert werden.

2. Verfahren nach Anspruch 1, bei dem die PTS eines Pakets in einem Paketkopfinformationsbereich formatiert ist.

3. Verfahren nach Anspruch 1, bei dem die Zahl der nacheinander an den Ausgang geschriebenen Bildpakete gezählt wird (S308), wobei ein Tonpaket unabhängig von den PTS-Werten der verglichenen Pakete an den Ausgang geschrieben wird, wenn der Zählwert einen Schwellenwert übersteigt (S311).

4. Verfahren nach Anspruch 1, bei dem ein Bildpaket an den Ausgang geschrieben wird, wenn verglichene Ton- und Bildpakete gleiche PTS-Werte haben (S307).

5. Verfahren nach Anspruch 3, bei dem der Schwellenwert anhand einer mittleren Bitrate des gesamten Tonbitstroms bestimmt wird.

6. Vorrichtung mit Mitteln zur Durchführung der Schritte des Verfahrens nach einem der Ansprüche 1 bis 5.

## Revendications

1. Méthode d'entrelacement d'un train de bits audio comprenant des paquets audio séquentiels et un train de bits vidéo comprenant des paquets vidéo séquentiels, et d'écriture des paquets vers une sortie, au moins certains des paquets audio et vidéo comportant des estampilles temporelles de présentation (PTS), caractérisée en ce qu'elle comprend les étapes consistant à :
pour chaque paquet audio et vidéo, déterminer si oui ou non une PTS est présente dans le paquet (S302,S303), et dans la négative, créer une PTS pour le paquet par estimation en utilisant une PTS provenant d'un paquet précédent à partir du même train de bits (S304) ;
comparer la PTS d'un paquet provenant d'un premier des trains de bits audio et vidéo avec la PTS d'un paquet provenant de l'autre train (S307), et écrire vers la sortie celui des paquets comparés qui présente la valeur PTS la plus faible (S307);
comparer la PTS d'un paquet non écrit vers la sortie dans l'étape précédente de la méthode, avec la PTS du paquet suivant, provenant du train à partir duquel un paquet a été écrit vers la sortie dans l'étape précédente de la méthode (S307), et écrire vers la sortie celui des paquets comparés dans l'étape présente de la méthode, qui possède la valeur PTS la plus faible. (S307) ; et,
répéter l'étape précédente de la méthode pour traiter d'autres paquets provenant des trains, multiplexant ainsi les trains de bits vidéo et audio, pour former un train de bits audio et vidéo unique.

2. Méthode selon la revendication 1, dans laquelle la PTS d'un paquet est formatée dans une zone d'information de tête de paquet.

3. Méthode selon la revendication 1, dans laquelle le nombre de paquets vidéo écrits séquentiellement vers la sortie est compté (S308), un paquet audio étant écrit vers la sortie indépendamment des valeurs PTS des paquets comparés si la valeur comptée excède une valeur de seuil (S311).

4. Méthode selon la revendication 1, dans laquelle un paquet vidéo est écrit vers la sortie si les paquets audio et vidéo comparés ont les mêmes valeurs PTS (S307).

5. Méthode selon la revendication 3, dans laquelle la valeur de seuil est déterminée par un débit binaire moyen du train total de bits audio.

6. Appareil comprenant des moyens pour exécuter les étapes de la méthode selon l'une quelconque des revendications 1 à 5.
